# EUROPEAN PATENT SPECIFICATION

(11) **EP 4 443 123 B1**
(45) Date of publication and mention of the grant of the patent: **20.08.2025**
(21) Application number: 23166862.5
(22) Date of filing: 05.04.2023
(51) Int. Cl.: G01K 7/01, G01K 11/3213, G01R 31/26, G01R 31/308, G01N 21/64, G01N 21/66, G02B 6/30, G02B 6/42

(54) **MONITORING DEVICE FOR A SEMICONDUCTOR COMPONENT, SEMICONDUCTOR DEVICE AND METHOD FOR MANUFACTURING THE SAME**
ÜBERWACHUNGSVORRICHTUNG FÜR EIN HALBLEITERBAUELEMENT, HALBLEITERBAUELEMENT UND VERFAHREN ZUR HERSTELLUNG DAVON
DISPOSITIF DE SURVEILLANCE POUR UN COMPOSANT SEMI-CONDUCTEUR, DISPOSITIF SEMI-CONDUCTEUR ET SON PROCÉDÉ DE FABRICATION

(43) Date of publication of application: 09.10.2024
(73) Proprietor: Bayerische Motoren Werke Aktiengesellschaft, 80809 München (DE); Compound Semiconductor Applications Catapult Limited, Newport, Wales NP10 8BE (GB); University of Warwick, Coventry CV4 7AL (GB)
(72) Inventor: BOCK, David, 85669 Pastetten (DE); VILLARRUEL-PARRA, Alejandro, 3919 Porsgrunn (NO); SEYMOUR, Geraint, Cardiff CF14 6EN (GB); BURTON, Christian, Caerphilly CF83 1EJ (GB); MAWBY, Phil, Coventry CV4 7AL (GB)
(74) Representative: HGF

(56) References cited:
- DE-A1- 102019 208 891
- US-B2- 9 627 571

## Description

The invention relates to a monitoring device for a semiconductor component, a semiconductor device and a method for manufacturing the same.

Semiconductor and compound semiconductors components for a variety of appliances, such as power train inverters, produce heat, and receive heat from other sources, which may raise the temperature of the semiconductor component. The temperature of the semiconductors forms one of the limits for wider system operation as excess temperature leads to catastrophic failure, but approaching the limit is often desirable from a performance perspective. Further, individual semiconductors are often used in groups and may not see identical current loading nor heating. There is therefore a demand for measuring or monitoring the temperature of critical semiconductor components, both individually and in groups. Operation of a semiconductor component may also be limited by a current running therethrough, so that knowledge of the current is also highly useful.

Known methods for measuring or monitoring the temperature of a semiconductor component, e.g. of a power module, suffer from the need to isolate temperature sensing elements from the high voltage present. I.e., the placement of temperature sensors in the prior art is associated with gaps in thermal paths, leading to a low responsiveness to fast temperature rises. A low responsiveness to these fast transient temperature changes significantly limits the accuracy and utility of the measurement. The more accurately temperature is measured, the more accurately power draw of a specific device can be interpreted. Once a specific device temperature is known, conclusions can be drawn about device health and performance limits, moreover this can be specific to the exact build.

It is known e.g. from JP2018107166A that SiC dies can emit light by electroluminescence. The emission is temperature dependent allowing interpolation of one from the other. As a result of the photoluminescence or electroluminescence effect, SiC components in power module assemblies such as largely used in vehicles like automobiles emit light. Due to the encapsulation required for high voltage operation, the light emission however is largely unobserved.

CN112485241A and CN112180227A disclose that detecting light emission of a SiC power device can be used for contact-less synchronous online detection of junction temperature and current of the silicon carbide power device working in high-temperature, high-voltage and high-current application occasions, with high precision and real-time performance. The measurement is done by a photoelectric detection circuit which receives the light from a light guide which is made of low-loss silica fibre. Fibre optics are however delicate to handle and connect, designed for high-intensity light sources, and sensitive to vibrations which usually occur in automobile appliances and other fields. In particular, a slight deviation in an angle or position under which a light guide is situated with respect to a light source can drastically change the amount of light coupled into the light guide. Similar problems can occur at the light emitting side of the light guide where the light is coupled out to be received by an optical sensor. Under strong vibrations, such deviations can occur which might be small but still have a strong impact on the light received, transported, and emitted by a light guide, thereby affecting reliably of light measurement, and conclusion drawn from such measurement. Moreover, a light receiving surface of a light guide is usually small, as it is adapted to receive strong light signals such as from a laser or LED. The photoluminescence or electroluminescence effects of an SiC die however are a side effect which is not very intense, as compared with common fibre optic laser light sources which are designed for high output. Also, the light emission of an SiC component is not concentrated but is distributed over a broad region all along a side surface of the component. For effectively collecting light of a relatively weak and dispersed source into a light guide, highly complex coupling setup would have to be developed and used. The mounting of such coupling setup with the die and with the light guide must be made with high precision and typically comprises either a lens stack or a lensed fibre. A similar method of detecting light emission of semiconductor components for temperature and/or current monitoring is disclosed in US9627571 B2. Therefore, temperature measurement or current measurement based on a light output of an SiC component under strong vibrations such as in automotive appliances is neither reliable nor cost effective with the solutions available in the art.

A technical problem of the invention is to create a monitoring device and method which enables accurate, responsive and reliable measurement of temperature or current of a semiconductor component under high current load even under rough mechanical conditions by utilizing electroluminescence or photoluminescence effects of the semiconductor element while enabling easy manufacture and providing resilient structure, a semiconductor device including a semi-conductor component having such monitoring device, and a method for manufacturing the same.

The technical problem is solved by the features of the independent claims. Further developments and advantageous embodiments are set forth in the subclaims.

An aspect of the invention is a monitoring device for a semiconductor component for an automobile appliance under high current and/or voltage, said semiconductor component having a light emitting surface and emitting photons at the light emitting surface when biased or reverse-biased, by way of electroluminescence or photoluminescence, in an amount depending on a temperature of, and/or a current through the semi-conductor component and/or its gate voltage, wherein the semiconductor component comprises particularly silicon carbide, the monitoring device including a light pipe insert having a light receiving end or light capturing end and a light emitting end or light extraction end, the light pipe insert being formed and placed to receive photoluminescence light or electroluminescence light from the semiconductor component through a light receiving surface formed at the light receiving end to face at least part of the light emitting surface of the semiconductor component, and to conduct the received light to the light emitting end for detecting the temperature of the semi-conductor component and/or a current through the semiconductor component and/or a gate voltage of the semiconductor component through an optical sensor configured to be coupled to the light emitting end of the light pipe insert, wherein the light pipe insert comprises a light pipe body having a foot section at the light receiving end and a shaft section extending from the foot section to the light emitting end, and wherein the light pipe body is a solid monolithic body made of a transparent material such as a transparent polymer or a typical glass.

A light pipe is a rigid body which is easy and inexpensive to manufacture, to handle and to mount. It can have a relatively large light receiving surface which is able to collect light over an elongated area like the side surface of an SiC die. The position and orientation of the light pipe with respect to the die or a sensor is not that critical like with a fibre-type light guide which typically has a narrow depth-of-field, at least within the boundaries of deviations expectable by vibration and assembly-tolerances in an automobile appliance. A complex and fragile coupling setup is not needed at the light receiving end or the light emitting end of a light pipe. By use of a light pipe insert according to the invention therefore enables accurate, responsive and reliable measurement of temperature and/or current of a semiconductor component and/or its gate voltage under high current load even under rough mechanical conditions by utilizing electroluminescence or photoluminescence effects of the semiconductor element while enabling easy manufacture and providing resilient structure, allowing for an indirect measurement by sensing the photon output linked with the respective condition. It will be noted that the semiconductor component may be a compound semiconductor component. Also, these materials of polymer or typical glass are naturally insulating, retaining the isolating function of an encapsulant of the semiconductor component, while achieving light conducting functions.

The semiconductor component may have a flat top surface and one or more side surfaces which surround the top surface and extend from a top surface or top face of a substrate where the semiconductor component is provided. The semiconductor component may have the light emitting surface formed in at least one side surface of the semiconductor component,. That part of the light emitting surface of the semiconductor component facing the light receiving surface of the light pipe insert may be at a straight part or a curved part of one side surface or a corner part of two side surfaces of the semiconductor component.

In embodiments, the light pipe insert may have a back face opposite to the light receiving surface, the back face being formed, preferably curved, to reflect light incident from the light receiving surface to a light emitting surface or light extraction surface provided at the light emitting end of the light pipe insert.

In embodiments, the light pipe insert may have a bottom face extending from the light receiving surface, the bottom face including an abutment surface and at least one indent being formed, preferably curved, to reflect light incident from the light receiving surface in a generally vertical direction to a light emitting surface provided at the light emitting end of the light pipe insert. The abutment surface may be formed to abut a surface of a substrate where the semiconductor component is provided.

In embodiments, light reflecting surfaces of the light pipe insert may be formed, preferably curved, in a direction across a path of light incident from the light receiving surface to focus the light to a point or a confined region within a light emitting surface provided at the light emitting end of the light pipe insert.

In embodiments, the light pipe insert may have a reflective or mirror-coating or reflection-enhancing surface treatment to improve internal reflection. This can be limited to particular reflective surfaces or surface parts, and can help transmitting the light with minimum loss due to side emission or absorption. Where the light pipe body is cylindrical, the reflective treatment may be all over the side surfaces.

Also, the light pipe insert may have an opaque coating or surface treatment to prevent transmission of light at surfaces other than the light receiving surface or a light emitting surface provided at the light emitting end of the light pipe insert. This can be limited to particular surfaces or surface parts, and can help avoiding side emission of light as well as incidence of light from outside. Such opacitizing treatment may be applied in addition to a reflective treatment.

Moreover, the light pipe insert may have a glossy coating or surface treatment to improve transmission of light at the light receiving surface or the light emitting surface of the light pipe insert.

Moreover, the light pipe insert may have a reflective coating or surface treatment to increase internal reflection, and improve the transmission of light along the light pipe's transmission path.

Furthermore, the light pipe insert may have an optical element such as a spherical or aspherical or Fresnel lens surface or lens stack at the light emitting end which may help capturing, focusing, and directing the light at the light emitting end.

In embodiments, the foot section has a wider cross-sectional area than the shaft section. The foot section may be formed to rest on a top surface or top face of a substrate where the semiconductor component is provided. With a wider cross-sectional are, mounting stability may be improved. The foot section may for example be formed like a collar. The shaft section may have any useful shape, and may have a swept rectangular profile, polygon, circular, elliptical profile, to form a straight, angled or curved (in one or more dimensions) piece. A swept profile in the sense of this application is a profile which has a similar cross-section at any place cut, but may follow an arbitrary path.

Here, the foot section may partly overlap a top surface of the semiconductor component. In other words, the foot section may rest on both top surfaces of the substrate and the semiconductor component which improves rigidity and reliability of mount, and ensures constant positioning of the light pipe insert with respect to the semiconductor component so that the direction of incident light can be held constant. For providing the overlap, the foot section may form a step, and the vertical part of the step may include the light receiving surface of the light pipe insert.

A gap between the light receiving surface of the light pipe insert and the light emitting surface of the semiconductor component may be filled with a transparent or semi-transparent medium such as glue or silicone.

If the foot section of the light pipe insert is thermally deformable, the foot section may be adapted to the shape of the semiconductor component during mounting such that the aforementioned step and the light receiving surface are exactly adapted to the semiconductor component. Here, a temperature range of thermal deformability is preferably well beyond a temperature which is expected to occur during operation of the semiconductor component, and well beneath a temperature the semiconductor component can passively endure without damage.

The monitoring device may further comprise an optical sensor formed and arranged for receiving light from a light emitting end of the light pipe insert, and providing sensor signals related to the received light from the light pipe insert. The optical sensor may be placed directly at a light emitting end of the light pipe insert, or at a remote location with the light from the light pipe insert being led to the sensor by other means.

The monitoring device may also further comprise a control unit formed for receiving and interpreting the sensor signals from the optical sensor to provide a sensor value related to the temperature of or a current through the semiconductor component the light pipe insert is placed at.

A further aspect of the invention is a semiconductor device for an automobile appliance, the semiconductor device comprising:
- a semiconductor component to be operated under high current and/or high voltage and emitting photons at a light emitting surface when biased or reverse-biased, by way of electroluminescence or photoluminescence, in an amount depending on temperature of and/or current through the semiconductor component and/or its gate voltage, the semiconductor component particularly comprising silicon carbide; and
- a monitoring device formed and arranged for detecting the temperature of the semiconductor component or a current through the semiconductor component based on photoluminescence light or electroluminescence light captured from the semiconductor component, wherein the monitoring device includes a light pipe insert having a light receiving end including a light receiving surface and a light emitting end, and placed at the semiconductor component such that the light receiving surface faces at least part of the light emitting surface of the semiconductor component, the light pipe insert being formed to conduct light received at the light receiving end to the light emitting end, the light emitting end being formed to be coupled to an optical sensor for detecting the temperature of the semiconductor component and/or a current through the semiconductor component and/or a gate voltage of the semiconductor component, wherein the monitoring device is formed according to the previous aspect including any of its embodiments,
and wherein the semiconductor component is encapsulated by an insulation layer such that a shaft section of the light pipe insert extends through and out of the insulation layer.

Here, the optical sensor senses a photon output linked with the temperature and/or current and/or gate voltage, and detection of the temperature and/or current and/or gate voltage makes use of that linkage.

A further aspect of the invention is a method for manufacturing the afore-described semiconductor device, the method comprising:
- placing the light pipe insert on a surface region adjacent to the semiconductor component such that the light receiving surface of the light pipe insert faces at least part of a light emitting surface of the semiconductor component;
- fixing the light pipe insert; and
- covering the semiconductor component by an insulation layer such that the light pipe extends through and out of the insulation layer,

wherein the fixing preferably includes connecting the light receiving end of the light pipe insert with the surface region adjacent to the semiconductor component, wherein the connecting includes at least one of:
   - pressing,
   - glueing, preferably by an optical glue,
   - thermally deforming
a foot section including the light receiving end of the light pipe insert.

The invention will now be further described in view of exemplary embodiment, referring to the accompanying drawings. In the drawings,
- Fig. 1: is a schematical side view of a semiconductor device having a monitoring device according to an embodiment of the invention, including an enlarged detail "A";
- Fig. 2: is a perspective view of a semiconductor device having a monitoring device according to another embodiment of the invention;
- Fig. 3A-3B: are a perspective view of a monitoring device according to another embodiment of the invention, a perspective view of a light pipe in the monitoring device, and a side view of the monitoring device with an exemplary optical path within the light pipe;
- Fig. 4A-4C: are two perspective views and a top view of monitoring devices including six particular variations of light pipes according to further embodiments of the invention, according to cases i-vi;
- Fig. 5A-5D: are schematical views of further particular variations of light pipes for monitoring devices according to further embodiments of the invention;
- Fig. 6: is a side view of a monitoring device according to a further embodiment of the invention;
- Fig. 7A, 7B: are side views of manufacturing stages of a monitoring device according to a further embodiment of the invention;

It will be noted that the drawings are schematic by nature and are made to illustrate preferred examples for embodying the invention, so that its concept can be understood.

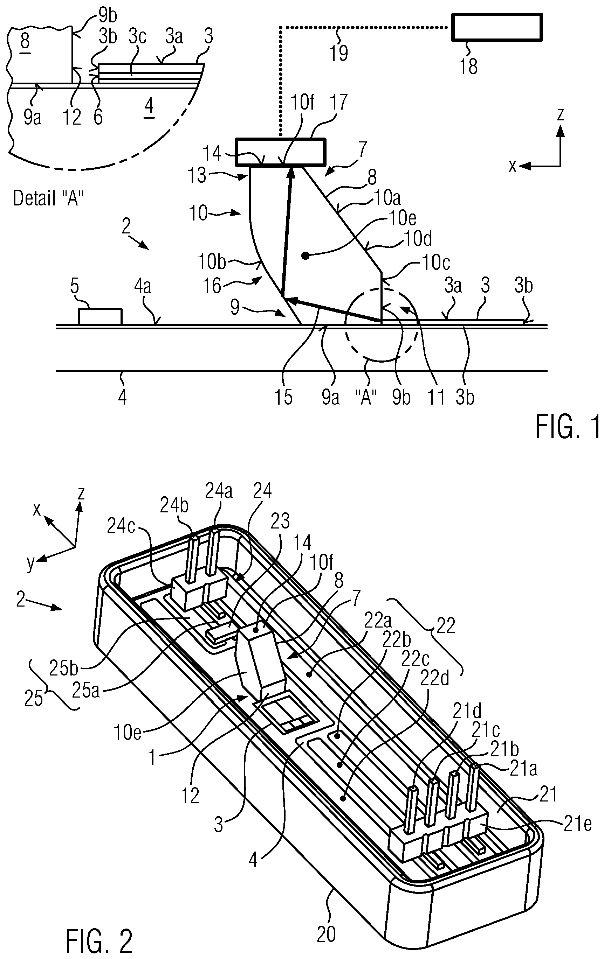

A monitoring device 1 according to an exemplary embodiment is used at a semiconductor device 2 (Figure 1).

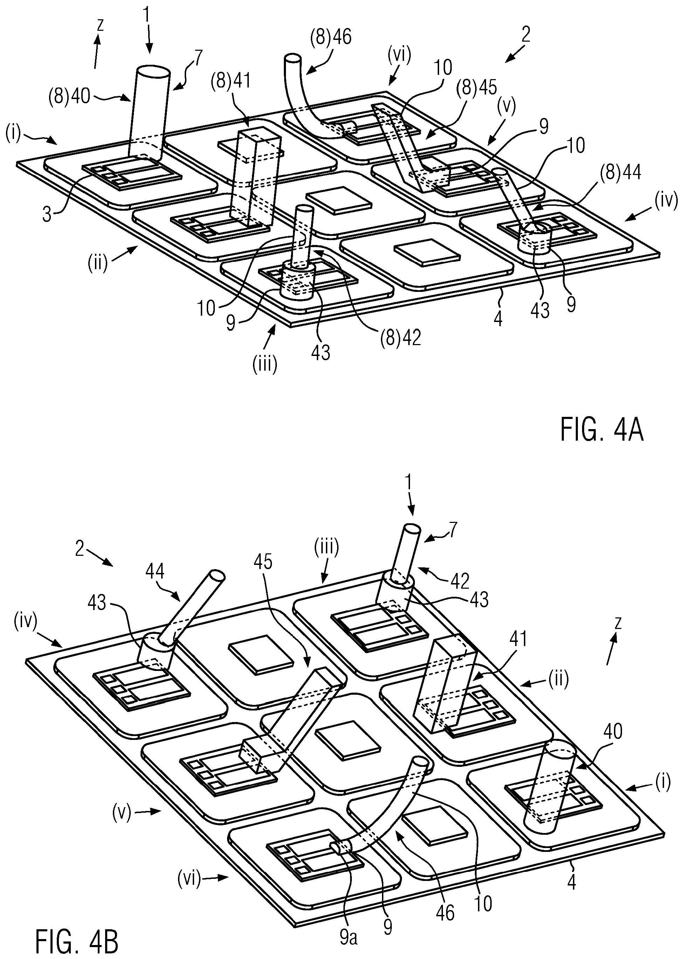

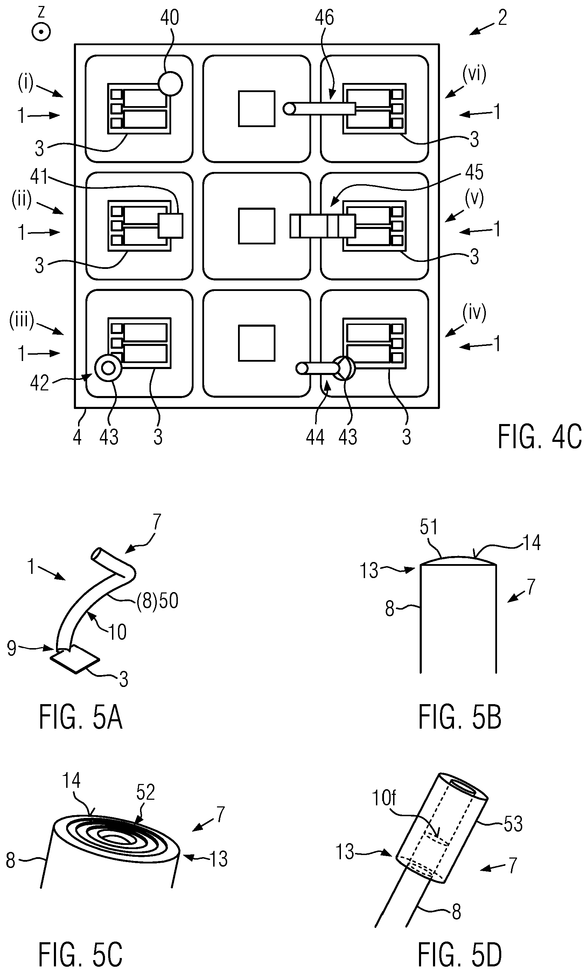

The semiconductor device 2 includes a semiconductor component 3 which is typically placed on a substrate 4, and may have further electronic elements 5. In some instances, the semi-conductor component 3 may be formed of or in the substrate 4 or be grown thereon. For the purposes of this description, a vertical direction z is defined to extend normal from a top face or top surface 4a of the substrate 4. Likewise, directions x, y perpendicular to each other and to the vertical direction z are defined within the top surface 4a of the substrate 4 to complete a cartesian coordinate system xyz. The directions x, y are horizontal directions. Here, the direction x may be defined to face away from one side surface 3b of the semiconductor component 3 where a light pipe insert 7 is placed (which is described below), and the direction y is along that side surface 3b. Where the light pipe insert 7 is placed at a corner of two side surfaces 3b of the semiconductor component 3 (see e.g. cases i, iii, iv in Figures 4A-4C), both directions x, y may be defined to face away from either of these two side surfaces 3b. This definition of horizontal directions x,y and vertical direction z is a local definition with respect to the semiconductor device 2, which is only for ease of explanation and is independent from an orientation of the semiconductor device 2 in a global space or environment.

The semiconductor component 3 has a top surface 3a facing in the vertical direction z, and a side surface 3b or several side surfaces 3b exposed from the top surface 4a of the substrate 4 to be accessible from a lateral side. The semiconductor component 3 is of a kind which exhibits an electroluminescence or photoluminescence effect such that it emits photons when biased (in case of a Diode) or reverse-biased (in case of a MOSFET). Typically such effect shows at a junction and in a region surrounding that junction which is addressed as a light emitting layer 3c. The light emitting layer 3c is exposed at each side surface 3b of the semi-conductor element 3 to form a light emitting surface 6 of the semiconductor component 3 (detail "A" in Figure 1). In other words, the light emitting surface 6 is a light emitting portion of the side surface 3b where the light emitting layer 3c is exposed. It will be noted that thickness of a top layer covering the light emitting layer 3c of the semiconductor component 3 is shown exaggerated in the drawing. The thickness of the light emitting layer 3c might vary substantially within the semiconductor component 3. The top layer may e.g. be a passivation layer with metallised contacts on top. Light cannot transition though these layers due to thickness. The electroluminescence or photoluminescence effect on biasing or reverse-biasing is known to arise in direct bandgap semiconductor components made of SiC (silicon carbide), in particular SiC 4H or SiC 6H polytypes. The intensity of photon emission according to the electroluminescence or photoluminescence effect is a convolved response to temperature, current conditions and gate voltage (the latter for MOSFETs only). SiC is widely used in power modules such as power MOSFETs for a variety of appliances such as traction inverters for electric vehicles or switching power supplies. Vehicles may include automobiles, trucks, motorcycles, trains, cableways, marine vessels, aircrafts. In the present embodiment, the semi-conductor component 3 is an SiC power MOSFET in an inverter of an automobile. It is desirable to know the temperature of the semiconductor component 3 for reliable function while exploiting its boundaries of operation. It is also desirable to know a current which the semiconductor component 3 endures, for the same reasons and for controlling the semiconductor component 3.

The monitoring device 1 of the present embodiment is provided for collecting the photons or at least a defined fraction of the photons emitted by the semiconductor component 3 due to the electroluminescence or photoluminescence effect, for thereby detecting the temperature of the semiconductor component 3 or a current through the semiconductor component 3. For this purpose, the monitoring device 1 includes a light pipe insert 7 that is placed at the semi-conductor component 3. The light pipe insert 7 includes a light pipe body 8. The light pipe body 8 is formed to conduct incident light by inner reflection from a light capturing end or light receiving end 11 to a light extraction end or light emitting end 13, see an exemplary light ray 15 in Figure 1. For optimizing a path of the light rays 15, the light pipe body 8 may have a reflective structure such as a curvature 16. The optimization of the path of the light rays 15 may refer to a minimum length and/or a minimum number of inner reflections.

The light pipe body 8 has a foot section 9 which abuts the semiconductor device 2, in particular the top surface 4a of the substrate 4, and a shaft section 10 which extends from the substrate 4. The foot section 9 and the shaft section 10 may be integrally formed or connected with each other. The foot section 9 may include, be included, or coincide with the light receiving end 11 of the light pipe insert 7.

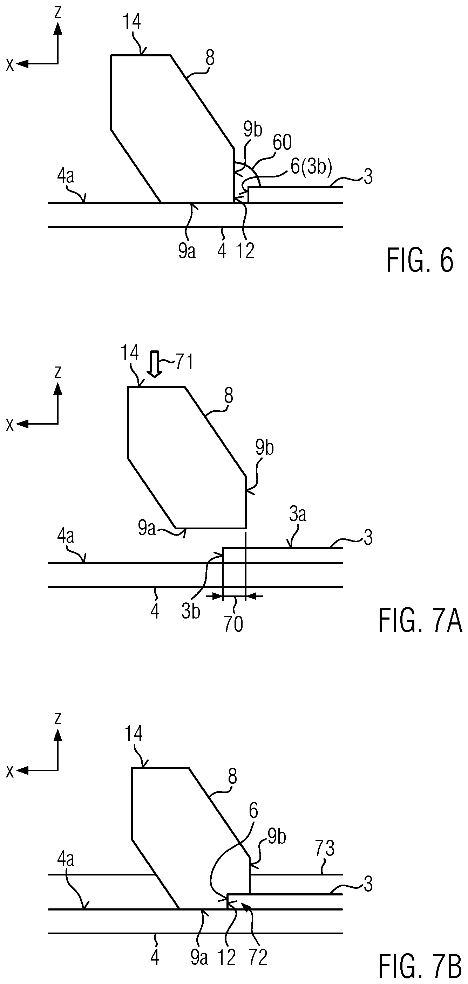

In the present embodiment, the foot section 9 has a bottom face 9a which abuts the top surface 4a of the substrate 4, and a front face 9b which faces the side surface 3b of the semiconductor component 3. Thereby, the front face 9b of the foot section 9 includes the light receiving surface 12 of the light pipe insert 7. It will be noted that in the enlarged detail "A" of Figure 1, a gap is shown between the front face 9b of the foot section 9 and the side surface 3b of the semiconductor component 3. Even if such gap may be present, it is preferable that the front face 9b of the foot section 9 tightly abuts the side surface 3b of the semi-conductor component 3 to reduce phase interface transits of light. If a considerable gap is present, it is preferable that such gap is filled by a transparent filler or glue 60 (see Figure 6).

In the present embodiment, the shaft section 10 has a front face 10a generally facing in a direction toward the semiconductor component 3 in the horizontal plane xy, in particular in negative x direction, and a back face 10b generally facing away from the semiconductor component 3 in the opposite direction to the front face 10a. The front face 10a of the shaft section has an erect part 10c generally extending in the vertical direction z, and a slant part 10d inclined from the vertical direction z away from the semiconductor component 3. The erect part 10c and the slant part 10d are flat. It will be noted that the front face 10a of the shaft section 10 is continuous with or coincides with the front face 9b of the foot section 9 to include the light receiving surface 12. At the light emitting end 13, a top end or top surface 10f of the shaft section 10 forms a light emitting surface 14 of the light pipe insert 7. The back face 10b includes the curvature 16 in x-z cross section for optimizing inner reflection. In x-y cross section, the back face 10b is flat in this embodiment which however is not limiting the invention. The back face 10b may have a curvature also in a cross-section perpendicular to the x-z plane and normal to the x-z curvature for focusing rays of light within the light pipe body.

The shaft section 10 also has two lateral faces 10e (see Figure 2) facing perpendicular to the facing directions of the front face 10a and the back face 10b. In other words, the lateral faces 10c are parallel with each other and are generally flat. In the present embodiment, the light pipe body 8 has a width, i.e. is a distance between the two lateral surfaces 10e, smaller than a width of the semiconductor component 3. This means that only a part of the light emitting surface 6 of the semiconductor component 3 is covered by the light receiving surface 12 of the light pipe insert 7. This in turn means that all the width of the light receiving surface 12 of the light pipe insert 7 receives light rays which are generally parallel.

At the light emitting end 13 of the light pipe insert 7, an optical sensor 17 may be coupled to receive light from a light emitting surface 14 of the light pipe body 8 (Figure 1). The optical sensor 17 may e.g. be a photodiode which has fast response time and low cost. The optical sensor 17 may be coupled to a processing unit 18 via data link 19. The optical sensor 17 may be optionally be lensed or left un-lensed. A filter may optionally be provided before the sensor 17 to select for changes in specific wavelengths. Instead of directly coupling the sensor 17 with the light emitting end 13 of the light pipe insert 7, light may optionally be brought to a preferred sensor location by free space optics, fibre optics, or a secondary light pipe system. The processing unit 18 may be a general purpose computer such as a laptop, desktop, phone or the like, or a special purpose control unit of an automobile, other vehicle, power plant or other appliance. The processing unit 18 may include a processor, data interface(s), permanent memory (ROM), working memory (RAM), flash memory, user interface(s), data reading/writing unit(s), and other elements as is generally known. The data link 19 may be a cable or wireless link and/or may be part of a bus structure, in particular field bus or vehicle bus such as a CAN bus, or the like. The optical sensor 17 is formed to output a sensor signal or sensor value in response to reception of light from the light pipe insert 7. The processing unit 19 is formed to receive and interpret a sensor signal from the optical sensor 17 to provide a measuring value related to the temperature and/or the current through the semiconductor component and/or its gate voltage. The interpretation of sensor signals may make use of dependencies between an electroluminence amount and the properties or conditions mentioned above which are determined beforehand or are known from literature. Examples of such literature are [1] J. Winkler, J. Homoth and I. Kallfass, "Electroluminescence-Based Junction Temperature Measurement Approach for SiC Power MOSFETs," in IEEE Transactions on Power Electronics, vol. 35, no. 3, pp. 2990-2998, March 2020, doi: 10.1109/TPEL.2019.2929426, and [2] S. Kalker, C. H. van der Broeck, L. A. Ruppert and R. W. De Doncker, "Next Generation Monitoring of SiC mosfets Via Spectral Electroluminescence Sensing," in IEEE Transactions on Industry Applications, vol. 57, no. 3, pp. 2746-2757, May-June 2021, doi: 10.1109/TIA.2021.3062773.

In the semiconductor device 2, the electronics parts on the substrate 4 can be arranged within a casing 20 (Figure 2). Besides the semiconductor component 3, other parts can be arranged on the substrate 4. In an exemplary embodiment which is neither limiting nor exhaustive, such other parts may include a power connecting unit 21 having a body part 21b and a number of connecting pins 21a-21d, conductive tracks 22a-22d of a high power wiring lines 22 leading from the power connecting unit 21 to the semiconductor component 3, the conductive tracks 22a-22d representing e.g. a source track, a drain track, a gate track and a ground track, an RTD sensor 23, a sensor connecting unit 24 having connection pins 24a, 24b and a body part 4c, conductive tracks 25a, 25b of a sensor wiring lines 25, an so on. The RTD sensor 23 can be provided for measuring a temperature of the die based on a temperature-dependent resistance change, and can be used for calibrating the measurement via the light pipe insert 7 and the optical sensor 17, for testing, or as a backup. Where the measuring characteristic of the optical measurement is reliably known, the RTD sensor 23 may also be omitted. It will be noted that the RTD sensor 23 will have a delay in measurement owing to the fact that a temperature change in the semiconductor component 3 needs some time to cause a temperature change in the substrate 4 beneath the RTD sensor 23. In contrast, the change of light emission from the semiconductor component 3 will instantaneously follow a temperature change in the semiconductor component 3, and thus can be detected instantaneously. The parts can be sealed by an insulating filler with only the connecting pins of the connecting units 21, 24, and the light emitting surface 14 of the light pipe insert 7 being exposed.

More than one semiconductor components 3 to be individually monitored may be played on one substrate 4 (see Figs. 4A-4C where different kinds of light pipe inserts 7 are applied for purposes of illustration).

The shape and build of the light pipe insert 7 and light pipe body 8 may be varied in numerous ways.

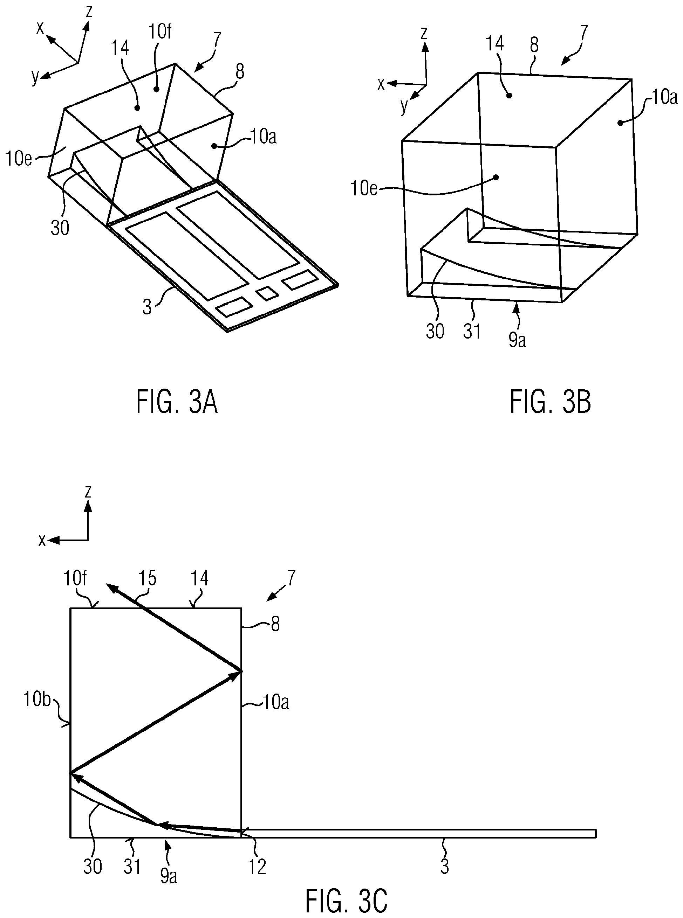

For example, the light pipe body 8 may be a cuboid body having rectangular faces 10a, 10b, 10e, 10f, 9a (Figures 3A-3C). An indent 30 may be formed within the bottom face 9a, having a reflective geometry to enhance guiding a ray of light 15 which enters the light receiving surface 12 into the vertical direction z, to eventually reach the light emitting surface 14. The indent 30 is formed only in a part of the bottom face 9a, such that abutment surfaces 31 remain for abutting the substrate. The indent 30 may be gently curved or polygonal, it may be curved generally in x-z cross section and may have or may not have a slight curvature also in a cross-section perpendicular to the x-z plane and normal to the x-z curvature. The indent 30 can be combined with any embodiment or variant shown or described herein.

The light pipe insert 7 may be formed and placed such that the foot section 9a partially covers the top surface 3a of the semiconductor component 3 (Figures 4A-4C).

In variants (i) to (vi) of light pipe inserts 7 shown in Figures 4A-4C, the light pipe body 8 may include:
(i) a flush cylindrical body 40 which extends vertically from the substrate 4,
(ii) a flush cuboid body 41 which extends vertically from the substrate 4,
(iii) a stepped cylindrical body 42 which extends vertically from the substrate 4, having a slender shaft section 10 and wider foot section 9 formed like a collar 43,
(iv) a stepped tilted cylindrical body 44 like in variant (iii) just that the slender shaft section 10 is inclined with respect to the vertical direction z,
(v) a stepped parallelepiped body 45, having a parallepiped-like shaft section 10 and cuboid foot section 9 extending horizontally,
(vi) bent cylindrical body 46 having a shaft section 10 formed as a bent slender pipe being continuous with the foot section 9 which extends horizontally to lay upon the substrate 4 and partly extending over the semiconductor component 3.

It will be noted that in each of cases (ii), (v), (vi) the light receiving surface 6 of the light pipe insert 7 faces a straight part of one side surface 3b of the semiconductor component 3, and in each of cases (i), (iii), (iv) the light receiving surface 6 of the light pipe insert 7 faces a corner part where two side surfaces 3b of the semiconductor component 3 meet. All the forms are designed for optimization in view of conduction of light from the light receiving end 11 to the light emitting end 13 of the light pipe insert 7, and stability of mount of the light pipe insert 7on the semiconductor device 2.

Further variants of light pipe inserts 7 are shown in Figures 5A-5D, which may include:
- a light pipe body 8 having a tortuous cylindrical body 50 (Figure 5A) where the cylindrical shaft portion 10 is bent in more than one direction after vertically emerging from the foot portion 9,
- a light emitting end 13 having the light emitting surface 14 with a spherical lens structure 51 (Figure 5B) for focusing emitted light preferentially,
- a light emitting end 13 having the light emitting surface 14 with a Fresnel-lens structure 52 (Figure 5C) for directing emitted light,
- a crosstalk barrier 53 in the form of an opaque pipe part sheathing the light emitting end 13 and extending beyond the top surface 10f of the shaft section 10 to form a shrouded exit (Figure 5D) which allows the use of several light pipe inserts simultaneously.

Many other variants and options are possible, such as the following:
- Any reflecting surface may be straight, curved in one dimension to focus the light upwards, i.e., in the direction of the light emitting end 13, or curved in two dimensions to focus to a particular point or region in the light emitting surface 14. Where such curvature appears convex from an outside view which in most cases will be preferable, it will have the effect of a concave curvature to internal reflection, and vice versa.
- Any reflecting surface may have a reflective coating or other surface treatment. Such coating or treatment may be designed to effect all or some wavelengths.
- The light pipe body may have indents or voids to encourage or channel internal reflection.
- The light emitting surface 14 of the light pipe insert 7 may have a shape, coating or other surface treatment to filter or let pass desired wavelengths.
- The light emitting end 13 may have a light emitting surface 14 with an aspherical lens structure or comprise a lens stack for focusing emitted light preferentially.
- The light pipe insert 7 may have a single refractive index at all points, or may be varied to achieve focusing using Gradient Index Imaging Optics.
- The light pipe insert 7 may be optically coherent to preserve the image of the side of the semiconductor component 3, allowing measurement of specific points on the die.
- The light pipe insert 7 may comprise a final surface incorporating a diffractive optical element. Here, a grating may be provided which is made to separate the light spatially by wavelength, allowing a sensor to only receive light from a narrow band of interest.

It will be noted that any variants or options may be mixed with each other and any embodiment shown or described herein, subject to feasibility and consistency.

A method for manufacturing the semiconductor device 2 having the monitoring device 1 includes at least the following steps:
- providing the light pipe insert 7; and
- arranging the light pipe insert 7 at the semiconductor component 3 such that a light receiving surface 12 of the light pipe insert 7 faces a light emitting surface 6 of the semiconductor component 3.

In a particular embodiment, the method may further include the step of gluing the light pipe insert 7 to the semiconductor device 2 by a glue 60 (see Figure 6). Here, a transparent glue 60 is preferably used at least in the region of a gap between the light receiving surface 12 of the light pipe insert 7 and the light emitting surface 6 of the semiconductor component 3. Other parts of the light pipe insert 7, in particular in a region between the light pipe insert 7 and the substrate 4, could be fixed by an opaque glue or other methods such as e.g. friction welding. It will be understood that the opacity or transparency of the glue 60 refers to the cured state of the glue 60.

In another embodiment, the method may include a pressing the light pipe insert 7 to the semiconductor device 2 in a pressing direction 71 such that a bottom face 9a of the foot section 9 of the light pipe body 8 has an overlap 70 with the top surface 3a of the semiconductor component 3 (Figure 7A). Here, the bottom face 9a may even deform under the pressure to form a step 72 which perfectly fits the contour of the semiconductor component 3 in the overlap 70, and the light receiving surface 12 of the light pipe insert 7 is formed by the forming of the step 72 to fit closely with the light emitting surface 6 of the semiconductor component 3 (Figure 7B).

The embodiments of the method can also be combined. For example, the step 72 may be formed beforehand in the light pipe insert 7. Here, a transparent glue 60 may be applied to fill possible gapes between the light pipe insert 7 and the semiconductor component 3. On the other hand, the pressing may include a friction welding of the parts under pressure.

The method can also include a step of applying an insulation layer 73 such as a sealing upon the semiconductor device 2 which covers the substrate 4 and semiconductor device 3 as well as other electronic elements 5, wirings 22, 24 etc. while the light pipe insert 7 as well as e.g. connectors of connecting units 21, 24 extend through the insulation layer 73 (Figure 7B). The insulation layer 73 may typically be opaque.

The providing of the light pipe insert 7 may include a forming the light pipe body 8, in particular by at least one of injection moulding, press-forming, die-cast moulding, gravity moulding, continuous casting (and chopping into parts of proper length), thermoforming, detailing, cutting, bending and/or twisting, finishing, surface treatment, mirror-coating, gloss-coating, opaque coating, polishing, roughening, assembling with other parts such as collar 43 or crosstalk barrier 53, as far as not formed together with the light pipe body 8.

The light pipe body 8 is formed as a solid monolithic body made of a transparent material such as a transparent polymer or a typical glass, including NBK7, Quartz, Sapphire, PE, PET, PMMA, Acrylic, PC, PETG, PVC, LSR, COCs, SAN, GPPS, ABS, MABS. Reflecting surfaces of the light pipe body 8 may be coated with a reflective or mirror coating. Other surfaces may be coated with a glossy coating or an opaque coating. A glossy coating can be useful e.g. for enhancing boundary transit at light receiving/emitting surfaces, and an opaque coating can be useful e.g. for shielding side emission or incidence from/into the light pipe body 8.

The method preferably includes coupling a light sensor to the light emitting end 13 of the light pipe insert 7, and connecting the optical sensor 17 with processing unit 18.

Any light pipe insert 7 described and depicted in this application can be provided separately to be used in or as a monitoring device and can establish an individual embodiment of the invention, with or without further equipment such as optical sensor 17, processing unit 18, link 19, or the like.

As said above, in a semiconductor device, multiple semiconductor components 3 may be provided, each being monitored by an individual light pipe insert 7. Each light pipe insert 7 may be coupled to an individual optical sensor 17. Alternatively, light emitted from multiple light pipe inserts 7 may be coupled to one optical sensor in parallel or serially or in interlaced or scanned fashion.

The monitoring device 1 using the light pipe inserts 7 according to the invention described herein exhibits the following advantages:
- The cost are low, so the invention is suited for use in volume applications. The light pipe inserts 7 are substantially cheaper to implement than fibre optic methods. A single insert is producible e.g. by injection moulding from an inexpensive polymer, or a typical glass. It avoids the use of expensive fibre-optics, and removes the need for board-level signal pins thus reducing component count.
- The light pipe insert 7 is a mechanically robust component in comparison with fibre optics. It is naturally insulating, retaining the isolating function of the encapsulant, while achieving the light transporting function.
- The invention is suitable for use adjacent to high voltage components and/or high temperature components.
- The light pipe insert 7 may be placed closer to the source of heat (ie., the semiconductor component 3) than temperature sensors can be at present, due to voltage safety and practical circuit design e.g. track and gap.
- The light pipe insert 7 with optical sensor 17 will provide a temperature reading several orders of magnitude faster than a board-mounted sensor like RTD sensor 23. Thereby, fast sensing regimes are enabled, with lower cost board level sensors.
- The invention provides a direct temperature measurement while other sensors estimate the temperature of the die as the distance guarantees a difference between the die and a traditional sensor. The invention using the light pipe insert 7 overcomes this, and provides rapid feedback. The temperature signal is decoupled from the noise generating substrate.
- The invention may be used to understand the current in a specific die [chip], given die vary, this is a big advantage as it is not possible with conventional methods.

The monitoring device 1 allows execution of a method for monitoring a semiconductor component for an automobile appliance under high current and/or by a monitoring device, said semiconductor element emitting photons when biased, by way of electroluminescence or photoluminescence, in an amount depending on temperature and/or current through the semiconductor component and/or its gate voltage, in particular including silicon carbide, said monitoring device being preferably formed according to any of the preceding claims, the method including:
- using a monitoring device, preferably formed according to any of the preceding claims, having a light pipe placed at the semiconductor component such that a light receiving surface of the light pipe can receive electroluminescence or photoluminescence light emitted from the semiconductor component;
- receiving light from a light emitting end of a light pipe which is placed at the semiconductor component such that a light receiving surface of the light pipe can receive light emitted from the semiconductor component;
- providing sensor signals related to the received light from the light pipe; and
- interpreting the sensor signals to provide a measuring value related to the temperature of and/or current through the semiconductor component and/or its gate voltage.

**List of reference signs**

| | | | |
|---|---|---|---|
| 1 | monitoring device | 19 | link |
| 2 | semiconductor device | 20 | casing |
| 3 | semiconductor component | 21 | power connecting unit |
| 3a | top surface | 22 | high power wiring |
| 3b | side surface | 23 | RTD sensor |
| 3c | light emitting layer | 24 | sensor connecting unit |
| 4 | substrate | 25 | sensor wiring |
| 4a | top surface | 30 | indent |
| 5 | electronic element | 31 | abutment surface |
| 6 | light emitting surface | 40 | cylindrical body |
| 7 | light pipe insert | 41 | cuboid body |
| 8 | light pipe body | 42 | stepped cylindrical body |
| 9 | foot section | 43 | collar |
| 9a | bottom face | 44 | stepped tilted cylindrical body |
| 9b | front face | | |
| 10 | shaft section | 45 | stepped parallelepiped body |
| 10a | front face | 46 | bent cylindrical body |
| 10b | back face | 50 | tortuous cylindrical body |
| 10c | erect part | 51 | spherical lens structure |
| 10d | slant part | 52 | Fresnel lens structure |
| 10e | lateral face | 53 | crosstalk barrier |
| 10f | top surface | 60 | glue |
| 11 | light receiving end | 70 | overlap |
| 12 | light receiving surface | 71 | pressing direction |
| 13 | light emitting end | 72 | step |
| 14 | light emitting surface | 73 | insulation layer |
| 15 | light ray | | |
| 16 | curvature | x,y | horizontal directions |
| 17 | optical sensor | z | vertical direction |
| 18 | processing unit | | |

This list is integral part of the description.

## Claims

1. A monitoring device (1) for a semiconductor component (3) for an automobile appliance under high current and/or voltage, said semiconductor component (3) having a light emitting surface (6) and emitting photons at the light emitting surface (6) when biased or reverse-biased, by way of electroluminescence or photoluminescence, in an amount depending on a temperature of and/or a current through the semiconductor component (3) and/or its gate voltage, wherein the semiconductor component (3) comprises particularly silicon carbide, the monitoring device (1) including a light pipe insert (7) having a light receiving end (11) and a light emitting end (13), the light pipe insert (7) being formed and placed to receive photoluminescence light or electroluminescence light from the semiconductor component (3) through a light receiving surface (12) formed at the light receiving end (11) to face at least part of the light emitting surface (6) of the semi-conductor component (3), and to conduct the received light to the light emitting end (13) for detecting the temperature of the semiconductor component (3) and/or a current through the semiconductor component (3) and/or a gate voltage of the semiconductor component (3) through an optical sensor (17) configured to be coupled to the light emitting end (13) of the light pipe insert (7), **characterised in that** the light pipe insert (7) comprises a light pipe body (8) having a foot section (9) at the light receiving end (11) and a shaft section (10) extending from the foot section (9) to the light emitting end (13), and wherein the light pipe body (8) is a solid monolithic body made of a transparent material such as a transparent polymer or a typical glass.

2. The monitoring device (1) of claim 1, wherein the semiconductor component (3) has the light emitting surface (6) formed in at least one side surface (3b) of the semiconductor component (3), wherein said part of the light emitting surface (6) of the semiconductor component (3) facing the light receiving surface (12) of the light pipe insert (7) is preferably at a straight part or a curved part of one side surface (3b) or a corner part of two side surfaces (3b) of the semiconductor component (3).

3. The monitoring device (1) of claim 1 or 2, wherein the light pipe insert (7) has a back face (10b) opposite to the light receiving surface (12), the back face (10b) being formed, preferably curved, to reflect light incident from the light receiving surface (12) to a light emitting surface (14) provided at the light emitting end (13) of the light pipe insert (7).

4. The monitoring device (1) of any of the preceding claims, wherein the light pipe insert (7) has a bottom face (9a) extending from the light receiving surface (12), the bottom face (9a) including an abutment surface (31) and at least one indent (30) being formed, preferably curved, to reflect light incident from the light receiving surface (12) in a generally vertical direction to a light emitting surface (14) provided at the light emitting end (13) of the light pipe insert (7).

5. The monitoring device (1) of any of the preceding claims, wherein light reflecting surfaces of the light pipe insert (7) are formed, preferably curved, in a direction across a path of light incident from the light receiving surface (12) to focus the light to a point or a confined region within a light emitting surface (14) provided at the light emitting end (13) of the light pipe insert (7).

6. The monitoring device (1) of any of the preceding claims, wherein the light pipe insert (7) has at least one of the following:
- a reflective or mirror-coating or reflection-enhancing surface treatment to improve internal reflection,
- an opaque coating or surface treatment to prevent transmission of light at surfaces other than the light receiving surface (12) or a light emitting surface (14) provided at the light emitting end (13) of the light pipe insert (7),
- a glossy coating or surface treatment to improve transmission of light at the light receiving surface (12) or the light emitting surface (14) of the light pipe insert (7),
- an optical element such as a spherical or aspherical or Fresnel lens surface or lens stack at the light emitting end (13).

7. The monitoring device (1) of any of the preceding claims, wherein the foot section (9) has a wider cross-sectional area than the shaft section (10).

8. The monitoring device (1) of claim 7, wherein the foot section (9) partly overlaps a top surface (3a) of the semiconductor component (3).

9. The monitoring device (1) of claim 7 or 8, wherein at least the foot section (9) of the light pipe insert (7) is thermally deformable.

10. The monitoring device (1) of any of the preceding claims, further comprising an optical sensor (17) formed and arranged for receiving light from a light emitting end (13) of the light pipe insert (7), and providing sensor signals related to the received light from the light pipe insert (7).

11. The monitoring device (1) of any of the preceding claims, wherein a gap between the light receiving surface (12) of the light pipe insert (7) and the light emitting surface (14) of the semiconductor component (3) is filled with a transparent filler or glue (60).

12. The monitoring device (1) of any of the preceding claims, further comprising a control unit formed for receiving and interpreting the sensor signals from the optical sensor (17) to provide a sensor value related to the temperature of or a current through the semi-conductor component (3) the light pipe insert (7) is placed at.

13. A semiconductor device for an automobile appliance, the semiconductor device comprising:
- a semiconductor component (3) to be operated under high current and/or high voltage and emitting photons at a light emitting surface (6) when biased or reverse-biased, by way of electroluminescence or photoluminescence, in an amount depending on temperature of and/or current through the semiconductor component (3) or its gate voltage, the semiconductor component (3) particularly comprising silicon carbide; and
- a monitoring device (1) formed and arranged for detecting the temperature of the semiconductor component (3) or a current through the semiconductor component (3) and/or its gate voltage based on photoluminescence light or electroluminescence light captured from the semiconductor component (3),
wherein the monitoring device (1) includes a light pipe insert (7) having a light receiving end (11) including a light receiving surface (12) and a light emitting end (13), and placed at the semiconductor component (3) such that the light receiving surface (12) faces at least part of the light emitting surface (6) of the semiconductor component (3), the light pipe insert (7) being formed to conduct light received at the light receiving end (11) to the light emitting end (13), the light emitting end (13) being formed to be coupled to an optical sensor (17) for detecting the temperature of the semiconductor component (3) and/or or a current through the semiconductor component (3) and/or a gate voltage of the semiconductor component (3), wherein the monitoring device (1) is formed according to any of the preceding claims, and wherein the semiconductor component (3) is encapsulated by an insulation layer (73) such that a shaft section (10) of the light pipe insert (7) extends through and out of the insulation layer (73).

14. A method for manufacturing the semiconductor device of claim 13, the method comprising:
- placing the light pipe insert (7) on a surface region adjacent to the semiconductor component (3) such that the light receiving surface (12) of the light pipe insert (7) faces at least part of a light emitting surface (6) of the semiconductor component (3);
- fixing the light pipe insert (7); and
- covering the semiconductor component (3) by an insulation layer (73) such that the light pipe insert (7) extends through and out of the insulation layer (73),
wherein the fixing preferably includes connecting the light receiving end (11) of the light pipe insert (7) with the surface region adjacent to the semiconductor component (3),
wherein the connecting includes at least one of:
- pressing,
- gluing, preferably by an optical glue (60),
- thermally or ultrasonically deforming
a foot section (9) including the light receiving end (11) of the light pipe insert (7).

## Patentansprüche

1. Überwachungsvorrichtung (1) für ein Halbleiterbauelement (3) für eine Kraftfahrzeugeinrichtung unter Hochstrom und/oder Hochspannung, wobei das Halbleiterbauelement (3) eine lichtemittierende Oberfläche (6) hat und im vorgespannten oder umgekehrt vorgespannten Zustand mittels Elektrolumineszenz oder Photolumineszenz Photonen an der lichtemittierenden Oberfläche (6) emittiert, und zwar in einer Menge, die von einer Temperatur des und/oder einem Strom durch das Halbleiterbauelement (3) und/oder seiner Gate-Spannung abhängt, wobei das Halbleiterbauelement (3) insbesondere Siliziumcarbid aufweist, die Überwachungsvorrichtung (1) einen Lichtleitereinsatz (7) mit einem lichtaufnehmenden Ende (11) und einem lichtemittierenden Ende (13) umfasst, der Lichtleitereinsatz (7) dafür ausgebildet und platziert ist, ein Photolumineszenz-Licht oder Elektrolumineszenz-Licht vom Halbleiterbauelement (3) durch eine lichtaufnehmende Oberfläche (12) aufzunehmen, die an dem lichtaufnehmenden Ende (11) so ausgebildet ist, dass sie zumindest einem Teil der lichtemittierenden Oberfläche (6) des Halbleiterbauelements (3) zugewandt ist, und um das aufgenommene Licht zu dem lichtemittierenden Ende (13) zu leiten, um die Temperatur des Halbleiterbauelements (3) und/oder einen Strom durch das Halbleiterbauelement (3) und/oder eine Gate-Spannung des Halbleiterbauelements (3) durch einen optischen Sensor (17) zu erfassen, der dafür ausgelegt ist, mit dem lichtemittierenden Ende (13) des Lichtleitereinsatzes (7) gekoppelt zu sein, **dadurch gekennzeichnet, dass**
der Lichtleitereinsatz (7) einen Lichtleiterkörper (8) mit einem Fußabschnitt (9) an dem lichtaufnehmenden Ende (11) und einem sich vom Fußabschnitt (9) zum lichtemittierenden Ende (13) erstreckenden Schaftabschnitt (10) aufweist, und wobei der Lichtleiterkörper (8) ein fester einstückiger Körper ist, der aus einem transparenten Material wie z. B. einem transparenten Polymer oder einem typischen Glas besteht.

2. Überwachungsvorrichtung (1) nach Anspruch 1, wobei das Halbleiterbauelement (3) die lichtemittierende Oberfläche (6) hat, die in mindestens einer Seitenfläche (3b) des Halbleiterbauelements (3) ausgebildet ist, wobei der Teil der lichtemittierenden Oberfläche (6) des Halbleiterbauelements (3), der der lichtaufnehmenden Oberfläche (12) des Lichtleitereinsatzes (7) zugewandt ist, sich vorzugsweise an einem geraden Teil oder einem gekrümmten Teil einer Seitenfläche (3b) oder an einem Eckteil zweier Seitenflächen (3b) des Halbleiterbauelements (3) befindet.

3. Überwachungsvorrichtung (1) nach Anspruch 1 oder 2, wobei der Lichtleitereinsatz (7) eine Rückseite (10b) entgegengesetzt zur lichtaufnehmenden Oberfläche (12) hat, und die Rückseite (10b) vorzugsweise gekrümmt ausgebildet ist, um Licht, das von der lichtaufnehmenden Oberfläche (12) her einfällt, zu einer lichtemittierenden Oberfläche (14) zu reflektieren, die an dem lichtemittierenden Ende (13) des Lichtleitereinsatzes (7) vorgesehen ist.

4. Überwachungsvorrichtung (1) nach einem der vorhergehenden Ansprüche, wobei der Lichtleitereinsatz (7) eine Bodenfläche (9a) hat, die sich ausgehend von der lichtaufnehmenden Oberfläche (12) erstreckt, wobei die Bodenfläche (9a) eine Auflagefläche (31) und mindestens eine Vertiefung (30) hat, die vorzugsweise gekrümmt ausgebildet ist, um Licht, das von der lichtaufnehmenden Oberfläche (12) her einfällt, in einer allgemein vertikalen Richtung zu einer lichtemittierenden Oberfläche (14) zu reflektieren, die an dem lichtemittierenden Ende (13) des Lichtleitereinsatzes (7) vorgesehen ist.

5. Überwachungsvorrichtung (1) nach einem der vorhergehenden Ansprüche, wobei lichtreflektierende Oberflächen des Lichtleitereinsatzes (7) vorzugsweise gekrümmt in einer Richtung über einen Weg des Lichts hinweg ausgebildet sind, das von der lichtaufnehmenden Oberfläche (12) her einfällt, um das Licht auf einen Punkt oder einen begrenzten Bereich innerhalb einer lichtemittierenden Oberfläche (14) zu fokussieren, die an dem lichtemittierenden Ende (13) des Lichtleitereinsatzes (7) vorgesehen ist.

6. Überwachungsvorrichtung (1) nach einem der vorhergehenden Ansprüche, wobei der Lichtleitereinsatz (7) mindestens eines der folgenden Merkmale aufweist:
- eine reflektierende Beschichtung oder Spiegelschicht oder eine reflexionserhöhende Oberflächenbehandlung zur Verbesserung der internen Reflexion,
- eine opake Beschichtung oder Oberflächenbehandlung zur Verhinderung der Übertragung von Licht an andere Oberflächen außer der lichtaufnehmenden Oberfläche (12) oder der lichtemittierenden Oberfläche (14), die an dem lichtemittierenden Ende (13) des Lichtleitereinsatzes (7) vorgesehen ist,
- eine Glanzbeschichtung oder Oberflächenbehandlung zur Verbesserung der Übertragung von Licht an der lichtaufnehmenden Oberfläche (12) oder der lichtemittierenden Oberfläche (14) des Lichtleitereinsatzes (7),
- ein optisches Element wie z. B. eine sphärische oder asphärische Oberfläche oder eine Fresnellinsen-Oberfläche oder ein Linsenstapel an dem lichtemittierenden Ende (13).

7. Überwachungsvorrichtung (1) nach einem der vorhergehenden Ansprüche, wobei der Fußabschnitt (9) eine breitere Querschnittsfläche als der Schaftabschnitt (10) hat.

8. Überwachungsvorrichtung (1) nach Anspruch 7, wobei der Fußabschnitt (9) eine Oberseite (3a) des Halbleiterbauelements (3) teilweise überlappt.

9. Überwachungsvorrichtung (1) nach Anspruch 7 oder 8, wobei zumindest der Fußabschnitt (9) des Lichtleitereinsatzes (7) thermisch verformbar ist.

10. Überwachungsvorrichtung (1) nach einem der vorhergehenden Ansprüche, darüber hinaus einen optischen Sensor (17) aufweisend, der dafür ausgebildet und eingerichtet ist, Licht vom einem lichtemittierenden Ende (13) des Lichtleitereinsatzes (7) zu empfangen und Sensorsignale bereitzustellen, die mit dem aufgenommenen Licht vom Lichtleitereinsatz (7) in Zusammenhang stehen.

11. Überwachungsvorrichtung (1) nach einem der vorhergehenden Ansprüche, wobei ein Spalt zwischen der lichtaufnehmenden Oberfläche (12) des Lichtleitereinsatzes (7) und der lichtemittierenden Oberfläche (14) des Halbleiterbauelements (3) mit einem transparenten Füllstoff oder Kleber (60) gefüllt ist.

12. Überwachungsvorrichtung (1) nach einem der vorhergehenden Ansprüche, darüber hinaus eine Steuereinheit aufweisend, die zum Empfangen und Interpretieren der Sensorsignale vom optischen Sensor (17) ausgebildet ist, um einen Sensorwert bereitzustellen, der mit der Temperatur des oder einem Strom durch das Halbleiterbauelement (3), an dem der Lichtleitereinsatz (7) platziert ist, in Zusammenhang steht.

13. Halbleitervorrichtung für eine Kraftfahrzeugeinrichtung, wobei die Halbleitervorrichtung aufweist:
- ein Halbleiterbauelement (3), das unter Hochstrom und/oder Hochspannung zu betreiben ist und im vorgespannten oder umgekehrt vorgespannten Zustand mittels Elektrolumineszenz oder Photolumineszenz Photonen an einer lichtemittierenden Oberfläche (6) emittiert, und zwar in einer Menge, die von einer Temperatur des und/oder einem Strom durch das Halbleiterbauelement (3) oder seiner Gate-Spannung abhängt, wobei das Halbleiterbauelement (3) insbesondere Siliziumcarbid aufweist; und
- eine Überwachungsvorrichtung (1), die dafür ausgebildet und eingerichtet ist, die Temperatur des Halbleiterbauelements (3) oder einen Strom durch das Halbleiterbauelement (3) und/oder seine Gate-Spannung auf der Grundlage von Photolumineszenz-Licht oder Elektrolumineszenz-Licht zu erfassen, das vom Halbleiterbauelement (3) eingefangen wird,
wobei die Überwachungsvorrichtung (1) einen Lichtleitereinsatz (7) mit einem lichtaufnehmenden Ende (11) einschließlich einer lichtaufnehmenden Oberfläche (12) und einem lichtemittierenden Ende (13) umfasst, und der am Halbleiterbauelement (3) so platziert ist, dass die lichtaufnehmende Oberfläche (12) zumindest einem Teil der lichtemittierenden Oberfläche (6) des Halbleiterbauelements (3) zugewandt ist, wobei der Lichtleitereinsatz (7) dafür ausgebildet ist, Licht, das an dem lichtaufnehmenden Ende (11) aufgenommen wird, zu dem lichtemittierenden Ende (13) zu leiten, wobei das lichtemittierende Ende (13) dafür ausgebildet ist, mit einem optischen Sensor (17) gekoppelt zu sein, um die Temperatur des Halbleiterbauelements (3) und/oder einen Strom durch das Halbleiterbauelement (3) und/oder eine Gate-Spannung des Halbleiterbauelements (3) zu erfassen, wobei die Überwachungsvorrichtung (1) nach einem der vorhergehenden Ansprüche ausgebildet ist, und wobei das Halbleiterbauelement (3) durch eine Isolationsschicht (73) so eingekapselt ist, dass sich ein Schaftabschnitt (10) des Lichtleitereinsatzes (7) durch die Isolationsschicht (73) hindurch und aus dieser heraus erstreckt.

14. Verfahren zur Herstellung der Halbleitervorrichtung nach Anspruch 13, wobei das Verfahren umfasst:
- Platzieren des Lichtleitereinsatzes (7) an einem an das Halbleiterbauelement (3) angrenzenden Oberflächenbereich in der Weise, dass die lichtaufnehmende Oberfläche (12) des Lichtleitereinsatzes (7) zumindest einem Teil einer lichtemittierenden Oberfläche (6) des Halbleiterbauelements (3) zugewandt ist;
- Befestigen des Lichtleitereinsatzes (7); und
- Bedecken des Halbleiterbauelement (3) durch eine Isolationsschicht (73) in der Weise, dass sich der Lichtleitereinsatz (7) durch die Isolationsschicht (73) hindurch und aus dieser heraus erstreckt,
wobei das Befestigen vorzugsweise umfasst, das lichtaufnehmende Ende (11) des Lichtleitereinsatzes (7) mit dem an das Halbleiterbauelement (3) angrenzenden Oberflächenbereich zu verbinden, wobei das Verbinden mindestens einen der folgenden Vorgänge umfasst:
- Andrücken,
- Verkleben, vorzugsweise mit einem optischen Kleber (60),
- thermisches Verformen oder über Ultraschall erfolgendes Verformen eines Fußabschnitts (9), der das lichtaufnehmende Ende (11) des Lichtleitereinsatzes (7) umfasst.

## Revendications

1. Dispositif de surveillance (1) pour un composant semi-conducteur (3) destiné à un équipement automobile soumis à des courants forts et/ou à des tensions élevées, le composant semi-conducteur (3) présentant une surface émettrice de lumière (6) et émettant, à l'état polarisé ou inversement polarisé, des photons par électroluminescence ou photoluminescence au niveau de la surface émettrice de lumière (6) en une quantité qui dépend d'une température du composant semi-conducteur (3) et/ou d'un courant traversant celui-ci et/ou de sa tension de grille, le composant semi-conducteur (3) comprenant en particulier du carbure de silicium, le dispositif de surveillance (1) comprenant un insert de guide de lumière (7) ayant une extrémité réceptrice de lumière (11) et une extrémité émettrice de lumière (13), l'insert de guide de lumière (7) étant conçu et placé pour recevoir une lumière photoluminescente ou électroluminescente provenant du composant semi-conducteur (3) à travers une surface réceptrice de lumière (12) formée sur l'extrémité réceptrice de lumière (11) de manière à être tournée vers au moins une partie de la surface émettrice de lumière (6) du composant semi-conducteur (3), et pour guider la lumière reçue vers l'extrémité émettrice de lumière (13) afin de détecter la température du composant semi-conducteur (3) et/ou un courant traversant le composant semi-conducteur (3) et/ou une tension de grille du composant semi-conducteur (3) par un capteur optique (17) conçu pour être couplé à l'extrémité émettrice de lumière (13) de l'insert de guide de lumière (7), **caractérisé en ce que**
l'insert de guide de lumière (7) comprend un corps de guide de lumière (8) ayant une section de base (9) à l'extrémité réceptrice de lumière (11) et une section de tige (10) s'étendant de la section de base (9) à l'extrémité émettrice de lumière (13), et sachant que le corps de guide de lumière (8) est un corps monobloc solide constitué d'un matériau transparent tel qu'un polymère transparent ou un verre typique.

2. Le dispositif de surveillance (1) selon la revendication 1, sachant que le composant semi-conducteur (3) comprend la surface émettrice de lumière (6) formée dans au moins une face latérale (3b) du composant semi-conducteur (3), la partie de la surface émettrice de lumière (6) du composant semi-conducteur (3) tournée vers la surface réceptrice de lumière (12) de l'insert de guide de lumière (7) étant située de préférence sur une partie droite ou une partie courbe d'une face latérale (3b) ou sur une partie d'angle de deux faces latérales (3b) du composant semi-conducteur (3).

3. Le dispositif de surveillance (1) selon la revendication 1 ou 2, sachant que l'insert de guide de lumière (7) comprend une face arrière (10b) opposée à la surface réceptrice de lumière (12), et la face arrière (10b) étant de préférence incurvée afin de réfléchir la lumière incidente provenant de la surface réceptrice de lumière (12) vers une surface émettrice de lumière (14) prévue à l'extrémité émettrice de lumière (13) de l'insert de guide de lumière (7).

4. Le dispositif de surveillance (1) selon l'une des revendications précédentes, sachant que l'insert de guide de lumière (7) comprend une surface de fond (9a) qui s'étend à partir de la surface réceptrice de lumière (12), la surface de fond (9a) comprenant une surface d'appui (31) et au moins un renfoncement (30), de préférence incurvé, pour réfléchir la lumière incidente provenant de la surface réceptrice de lumière (12) dans une direction généralement verticale vers une surface émettrice de lumière (14) prévue à l'extrémité émettrice de lumière (13) de l'insert de guide de lumière (7).

5. Le dispositif de surveillance (1) selon l'une des revendications précédentes, sachant que des surfaces réfléchissant la lumière de l'insert de guide de lumière (7) sont de préférence courbées dans une direction traversant le trajet de la lumière incidente provenant de la surface réceptrice de lumière (12) afin de focaliser la lumière sur un point ou une zone limitée à l'intérieur d'une surface émettrice de lumière (14) prévue à l'extrémité émettrice de lumière (13) de l'insert de guide de lumière (7).

6. Le dispositif de surveillance (1) selon l'une des revendications précédentes, l'insert de guide de lumière (7) présentant au moins l'une des caractéristiques suivantes :
- un revêtement réfléchissant ou une couche miroir ou un traitement de surface augmentant la réflexion pour améliorer la réflexion interne,
- un revêtement opaque ou un traitement de surface pour empêcher la transmission de lumière vers d'autres surfaces que la surface réceptrice de lumière (12) ou la surface émettrice de lumière (14) prévue à l'extrémité émettrice de lumière (13) de l'insert de guide de lumière (7),
- un revêtement brillant ou un traitement de surface pour améliorer la transmission de la lumière au niveau de la surface réceptrice de lumière (12) ou de la surface émettrice de lumière (14) de l'insert de guide de lumière (7),
- un élément optique tel qu'une surface sphérique ou asphérique ou une surface à lentille de Fresnel ou un empilement de lentilles à l'extrémité émettrice de lumière (13).

7. Le dispositif de surveillance (1) selon l'une des revendications précédentes, sachant que la section de base (9) a une section transversale plus large que la section de tige (10).

8. Le dispositif de surveillance (1) selon la revendication 7, sachant que la section de base (9) recouvre partiellement une face supérieure (3a) du composant semi-conducteur (3).

9. Le dispositif de surveillance (1) selon la revendication 7 ou 8, sachant qu'au moins la section de base (9) de l'insert de guide de lumière (7) est thermoformable.

10. Le dispositif de surveillance (1) selon l'une des revendications précédentes, comprenant en outre un capteur optique (17) conçu et agencé pour recevoir la lumière provenant d'une extrémité émettrice de lumière (13) de l'insert de guide de lumière (7) et pour fournir des signaux de capteur qui sont en relation avec la lumière reçue de l'insert de guide de lumière (7).

11. Le dispositif de surveillance (1) selon l'une des revendications précédentes, sachant qu'un espace entre la surface réceptrice de lumière (12) de l'insert de guide de lumière (7) et la surface émettrice de lumière (14) du composant semi-conducteur (3) est rempli d'un matériau de remplissage transparent ou d'une colle transparente (60).

12. Le dispositif de surveillance (1) selon l'une des revendications précédentes, comprenant en outre une unité de commande conçue pour recevoir et interpréter les signaux de capteur provenant du capteur optique (17) afin de fournir une valeur de capteur qui est en relation avec la température du composant semi-conducteur (3) ou avec un courant traversant celui-ci, au niveau duquel l'insert de guide de lumière (7) est placé.

13. Dispositif semi-conducteur pour un équipement automobile, le dispositif semi-conducteur comprenant :
- un composant semi-conducteur (3) destiné à fonctionner sous courants forts et/ou tensions élevées et émettant, à l'état polarisé ou inversement polarisé, des photons par électroluminescence ou photoluminescence au niveau d'une surface émettrice de lumière (6) en une quantité qui dépend d'une température du composant semi-conducteur (3) et/ou d'un courant traversant celui-ci et/ou de sa tension de grille, le composant semi-conducteur (3) comprenant notamment du carbure de silicium ; et
- un dispositif de surveillance (1) conçu et agencé pour détecter la température du composant semi-conducteur (3) ou un courant traversant le composant semi-conducteur (3) et/ou sa tension de grille sur la base de la lumière de photoluminescence ou de la lumière d'électroluminescence captée par le composant semi-conducteur (3),
le dispositif de surveillance (1) comprenant un insert de guide de lumière (7) ayant une extrémité réceptrice de lumière (11), y compris une surface réceptrice de lumière (12), et une extrémité émettrice de lumière (13), et étant placé au niveau du composant semi-conducteur (3) de telle sorte que la surface réceptrice de lumière (12) soit tournée vers au moins une partie de la surface émettrice de lumière (6) du composant semi-conducteur (3), l'insert de guide de lumière (7) étant conçu pour guider la lumière captée à l'extrémité réceptrice de lumière (11) vers l'extrémité émettrice de lumière (13), l'extrémité émettrice de lumière (13) étant conçue pour être couplée à un capteur optique (17) afin de détecter la température du composant semi-conducteur (3) et/ou un courant traversant le composant semi-conducteur (3) et/ou une tension de grille du composant semi-conducteur (3), le dispositif de surveillance (1) étant conçu selon l'une des revendications précédentes, et le composant semi-conducteur (3) étant encapsulé par une couche isolante (73) de telle sorte qu'une section de tige (10) de l'insert de guide de lumière (7) s'étende à travers la couche isolante (73) et hors de celle-ci.

14. Procédé de fabrication du dispositif semi-conducteur selon la revendication 13, le procédé comprenant :
- le placement de l'insert de guide de lumière (7) au niveau d'une zone de surface adjacente au composant semi-conducteur (3) de telle sorte que la surface réceptrice de lumière (12) de l'insert de guide de lumière (7) soit tournée vers au moins une partie d'une surface émettrice de lumière (6) du composant semi-conducteur (3) ;
- la fixation de l'insert de guide de lumière (7) ; et
- le recouvrement du composant semi-conducteur (3) par une couche isolante (73) de telle sorte que l'insert de guide de lumière (7) s'étende à travers la couche isolante (73) et hors de celle-ci,
la fixation comprenant de préférence la liaison de l'extrémité réceptrice de lumière (11) de l'insert de guide de lumière (7) avec la zone de surface adjacente au composant semi-conducteur (3), la liaison comprenant au moins l'une des opérations suivantes :
- pressage,
- collage, de préférence avec une colle optique (60),
- déformation thermique ou déformation par ultrasons d'une section de base (9) qui comprend l'extrémité réceptrice de lumière (11) de l'insert de guide de lumière (7).
